# EUROPÄISCHE PATENTSCHRIFT

(11) **EP 2 549 003 B1**
(45) Veröffentlichungstag und Bekanntmachung des Hinweises auf die Patenterteilung: **14.06.2017**
(21) Anmeldenummer: 12169481.4
(22) Anmeldetag: 25.05.2012
(51) Int. Cl.: D04B 37/02, G06F 17/50

(54) **Verfahren und Vorrichtung zur Maschendarstellung**
Method and device for stitch visualisation
Procédé et dispositif destinés à la représentation de mailles

(30) Priorität: 02.07.2011 DE 102011106401
(43) Veröffentlichungstag der Anmeldung: 23.01.2013
(73) Patentinhaber: H. Stoll AG & Co. KG, 72760 Reutlingen (DE)
(72) Erfinder: Ertl, Gerhard, Dr., 8010 Graz (AT)
(74) Vertreter: Kohler Schmid Möbus Patentanwälte

(56) Entgegenhaltungen:
- EP-A1- 1 452 985
- EP-A1- 2 116 946

## Beschreibung

Die Erfindung betrifft ein Verfahren zur dreidimensionalen Darstellung von Maschen auf einer Einrichtung zum Entwurf von auf einer Strick- oder Wirkmaschine herzustellenden Maschenerzeugnissen sowie eine entsprechende Entwurfseinrichtung.

Zur Erleichterung des Entwurfs von Maschenerzeugnissen, die auf einer Strick- oder Wirkmaschine hergestellt werden sollen, verfügen moderne Strick- und Wirkmaschinen über Entwurfseinrichtungen, auf denen die Maschenerzeugnisse auf unterschiedliche Weise darstellbar sind.

Insbesondere für stricktechnisch weniger gut ausgebildete Designer ist dabei die möglichst realitätsgetreue Darstellung des Maschenerzeugnisses von Vorteil. Diese realitätsgetreue Darstellung kann auf unterschiedliche Weise realisiert werden.

In der Regel geht man bei der Darstellung von Maschen oder Strickfäden in einer Entwurfseinrichtung davon aus, dass der Faden einen runden oder elliptischen Querschnitt hat. Die Oberfläche des Garns wird üblicherweise mit dem so genannten Texture Mapping dargestellt. Man verwendet also beispielsweise ein Bild eines gescannten Fadens und "klebt" dieses Bild auf eine zylindrische Oberfläche, mit der die Fadenoberfläche angenähert wird. Die Textur enthält dabei auch Informationen über die Transparenz des Fadens. Unterschiedliche Fadentypen lassen sich so durch unterschiedliche Bilder (Texturen) darstellen. Weiter muss eine Möglichkeit vorgesehen werden, beliebig gebogene Zylinder darzustellen, da der Strickfaden in einem Maschenerzeugnis mehrfache Richtungsänderungen erfährt.

Die heute übliche Grafikkarten-Hardware erlaubt allerdings nur die Darstellung von ebenen Flächen. Daher müssen die Zylinder durch eine Menge von ebenen Flächen approximiert werden. Ein Verfahren zu einer solchen Maschendarstellung ist beispielsweise aus der EP 2 226 735 A1 bekannt. Bei diesem Verfahren wird eine Leitkurve verwendet, welche die Mittellinie des den Faden repräsentierenden Zylinders definiert. An dieser Leitkurve wird ein Polygon entlanggeschoben. Der Mittelpunkt des Polygons liegt dabei auf der Leitkurve, und der Normalvektor des Polygons ist gleich der Tangente der Leitkurve an der entsprechenden Stelle.

Als Polygone werden häufig regelmäßige Sechsecke verwendet. Es können aber auch Polygone mit einer anderen Anzahl von Eckpunkten eingesetzt werden. Die Polygone werden dabei üblicherweise in regelmäßigen Abständen auf der Leitkurve positioniert. Die Eckpunkte aufeinanderfolgender Polygone werden sodann durch Dreiecke verbunden. Dadurch ergibt sich ein Formrohr mit sechseckigem Querschnitt, das den Zylinder approximiert. Bei dem bekannten Verfahren werden zehn Sechsecke pro Masche verwendet. Dies bedeutet, dass pro Masche 120 Dreiecke erzeugt werden.

Der Nachteil dieser bekannten Verfahren liegt darin, dass zu viele Flächen erzeugt werden, da das Verfahren auch Flächen für die Rückseite des Garns, die nicht sichtbar ist, erzeugt. Bei sehr hoher Auflösung der Darstellung auf einer Anzeigeeinrichtung wird die Darstellung außerdem fehlerhaft, da sie stets aus einer festen Anzahl von Grundflächen besteht.

Bei kleinen Zoomstufen dagegen wird die Darstellung sehr langsam. Pro Masche werden 120 Dreiecke verwendet, sodass bei einer typischen Musterfolge von einer Million Maschen 120 Millionen Dreiecke dargestellt werden müssen. Dies ist auch mit modernen Grafikkarten nur mit hohen Rechenzeiten möglich. Bei einer typischen Bildschirmauflösung von 1600 x 1200 Pixeln überdeckt jede Masche im Durchschnitt zwei Pixel. Es ist daher nicht sinnvoll, die Farbe dieser beiden Pixel durch Füllen von 120 Dreiecken zu bestimmen.

Ein weiterer Nachteil des bekannten Verfahrens liegt darin, dass die Vorderseite des Garns durch drei Vierecke oder sechs Dreiecke dargestellt wird. Auch dies ist nicht notwendig, da die sichtbare Seite des Fadens auch durch nur ein Viereck bzw. zwei Dreiecke darstellbar ist. Außerdem werden auch für Maschen, die nicht auf dem Bildschirm dargestellt werden, Dreiecke berechnet, was einen unnötig hohen Speicherbedarf erfordert.

Aus der EP 1 452 985 A1 sind ein Verfahren zur dreidimensionalen Darstellung von Maschen auf einer Einrichtung zum Entwurf von auf einer Strick- oder Wirkmaschine hergestellten Maschenerzeugnissen sowie eine Einrichtung zum Entwurf von auf einer Strick- oder Wirkmaschine hergestellten Maschenerzeugnissen bekannt, mit denen jede Masche durch eine Fläche darstellbar ist, die sich aus einer Anzahl von geometrischen Grundformen zusammensetzt. Die Masche wird hier jedoch durch eine gleichbleibende Anzahl von zweidimensionalen Grundformen angenähert.

In der EP 2 116 946 A1 sind dreidimensionale Grundformen erwähnt, deren Aufbau in Abhängigkeit der Darstellungsgröße der Masche veränderbar ist, und die auf einer zweidimensionalen Anzeigevorrichtung als 2D Strukturen dargestellt werden. Damit zeigt dieses Dokument ein Verfahren nach dem Oberbegriff von Anspruch 1 und eine Vorrichtung nach dem Oberbegriff von Anspruch 6. Der vorliegenden Erfindung liegt die Aufgabe zugrunde, ein Verfahren zur dreidimensionalen Darstellung von Maschenerzeugnissen sowie eine Einrichtung zum Entwurf von Maschenerzeugnissen mit der Möglichkeit einer dreidimensionalen Darstellung von Maschen vorzuschlagen, mit deren Hilfe eine realitätsgetreue dreidimensionale Darstellung von Maschen mit deutlich reduzierter Rechenzeit und geringerem Speicherbedarf möglich ist als bei den bekannten Verfahren.

Die Aufgabe wird gelöst durch ein Verfahren zur Darstellung von Maschen mit den Merkmalen des Anspruchs 1.

Je nach Auflösung der Maschendarstellung sind unterschiedliche Anzahlen von Grundformen nötig, um das Maschenbild realitätsgetreu zu gestalten. Bei nur geringer Auflösung wird ein guter optischer Eindruck bereits mit wenigen Grundformen erreicht, während eine hohe Auflösung der Maschendarstellung eine größere Anzahl von Grundformen benötigt. Weiter lassen sich gerade Maschenabschnitte ebenfalls durch weniger Grundformen approximieren als stark gekrümmte Bereiche. Zweckmäßigerweise wird daher die Anzahl der die Fläche bildenden Grundformen umso höher gewählt, umso größer die Maschendarstellung auf der Anzeigeeinrichtung und/oder je stärker die Krümmung einzelner Maschenabschnitte ist.

Die Fläche, mit der die Maschenkontur approximiert wird, kann von lauter gleichartigen oder von unterschiedlichen Grundformen gebildet werden. Dabei können die Grundformen vorzugsweise ebene Polygone, beispielsweise Dreiecke oder Vierecke sein.

Die räumliche Struktur der Maschen wird durch Schattierung (Shading) und Texture Mapping dargestellt. Dazu kann die Helligkeit jedes Bildpunkts in Abhängigkeit des Normalvektors des Fadens an der entsprechenden Position bestimmt werden. Jedem Eckpunkt der Grundformen wir dazu ein Normalvektor zugeordnet. Der Normalvektor des Fadens innerhalb einer Grundform wird dann durch Interpolieren der Normalvektoren in den Eckpunkten der Grundformen approximiert. Der Normalvektor in den Eckpunkten der Grundform hängt vom Normalvektor des echten Fadens in diesem Punkt ab, wobei die jeweils für einen Betrachter sichtbare Seite des Fadens durch einen Halbzylinder mit einer Breite, die dem Fadendurchmesser entspricht, angenähert wird. Auf diese Weise werden keine Berechnungen für die nicht sichtbare Seite des Fadens vorgenommen, was die Rechenzeit halbiert und außerdem Speicherplatz spart. Der Faden kann durch eine streifenförmige Fläche approximiert werden, die eine Breite entsprechend dem Durchmesser des Fadens aufweist.

Eine weitere Steigerung der Realitätsnähe lässt sich dadurch erzielen, dass die Texturdaten auch Informationen über die Transparenz des Fadens enthalten können.

Die Erfindung betrifft außerdem eine Einrichtung zum Entwurf von auf einer Strick- oder Wirkmaschine hergestellten Maschenerzeugnissen, mit den Merkmalen des Anspruchs 6. Diese Simulationseinrichtung enthält eine Einrichtung zum Texture Mapping, mit welcher der räumliche Eindruck der durch die geometrischen Grundformen approximierten Maschen herstellbar ist.

Mit der Texture-Mapping-Einrichtung wird die räumliche Struktur des die Masche bildenden Fadens mittels einer Normal-Vektordarstellung der Eckpunkte der Grundformen visualisiert. Dabei werden jedem Eckpunkt mehrere Texturkoordinaten sowie ein Normalvektor zugeordnet. Die Texturkoordinaten legen die Position des Eckpunkts innerhalb des Texturbildes fest. Der Normalvektor wird in Abhängigkeit des Normalvektors des echten Fadens im entsprechenden Eckpunkt bestimmt. Dadurch lassen sich auch Krümmungen des Fadens sehr realitätsnah darstellen.

Mit der Texture-Mapping-Einrichtung wird für die Berechnungen außerdem nur die sichtbare Seite des Fadens durch einen Halbzylinder mit einer Breite entsprechend dem Durchmesser des Fadens angenähert. Dadurch lässt sich die Gesamtgeschwindigkeit der Bilderzeugung erheblich steigern, ohne die Qualität der Maschendarstellung zu verringern. Die sichtbare Seite des Fadens kann durch eine streifenförmige Fläche mit einer Breite entsprechend dem Fadendurchmesser dargestellt werden.

Die beigefügte Zeichnung verdeutlicht ein Ausführungsbeispiel eines erfindungsgemäßen Verfahrens anhand von Prinzipdarstellungen der wichtigsten Verfahrensschritte.

Im Einzelnen zeigen:
- Fig. 1 bis 3:: Die Darstellung einer Masche als Approximation von Grundformen in unterschiedlichen Auflösungen;
- Fig. 4: eine Approximation einer Fadendarstellung im Querschnitt;
- Fig. 5: eine der Fig. 4 entsprechende Darstellung mit interpolierten Normalvektoren;
- Fig. 6: eine durch eine streifenförmige Fläche approximierte Fadendarstellung im Querschnitt.

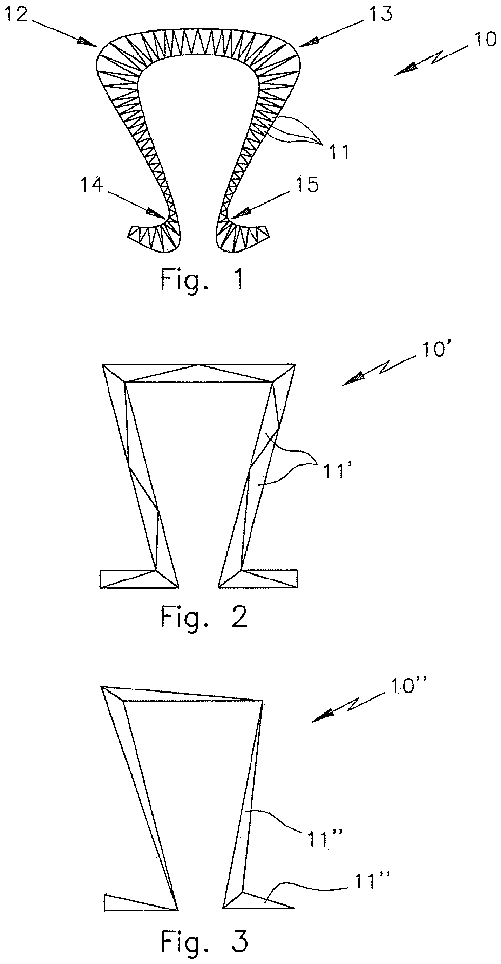

Fig. 1 zeigt die Darstellung einer Masche 10 mit einer hohen Auflösung. Für eine realitätsnahe Darstellung der Masche 10 wird hier eine hohe Anzahl von Dreiecken 11 benötigt, um die Maschenform zu approximieren. In den Krümmungsbereichen 12, 13, 14, 15 ist die Anzahl der Dreiecke 11 dabei höher als in den übrigen Bereichen.

In Fig. 2 ist eine Masche 10' mit einer mittleren Auflösung gezeigt. Für eine realitätsnahe Darstellung der Masche 10' werden hier deutlich weniger Dreiecke 11' benötigt, um die Maschenkontur realitätsgetreu abbilden zu können, als bei hoher Auflösung gemäß Fig. 1.

In Fig. 3 ist eine Maschendarstellung 10" in einer äußerst geringen Auflösung gezeigt. Maschendarstellungen in dieser Zoomstufe kommen mit nur 5 Dreiecken für die Approximation der Masche aus.

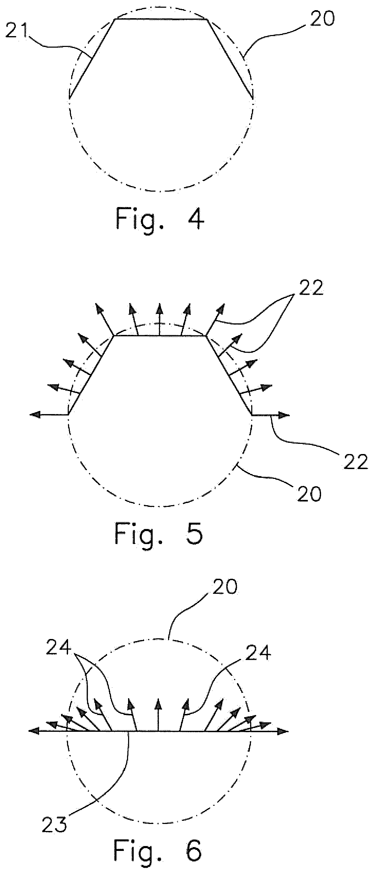

Fig. 4 verdeutlicht die Approximation der Darstellung eines Fadens 20, der durch einen Kreis in der Querschnittsdarstellung in Fig. 4 angedeutet ist. Die sichtbare Seite des Fadens 20, hier die obere Seite, wird durch einen Halbzylinder 21 approximiert, der in diesem nicht erfindungsgemäßen Beispiel der Hälfte eines Zylinders mit einem sechseckigen Querschnitt entspricht. Um die räumliche Struktur des Fadens 20 zu approximieren, wird eine Textur-Vektordarstellung für die Eckpunkte der Dreiecke 11, 11', 11" aus den Fig. 1 bis 3 verwendet, wobei die Textur-Vektordarstellung von den in Fig. 5 gezeigten interpolierten Normalvektoren 22 abhängt.

Fig. 6 verdeutlicht, dass der Faden 20 auch durch eine streifenförmige Fläche 23 approximiert werden kann, deren Breite dem Durchmesser des Fadens 20 entspricht. Die Richtungen der Normalvektoren des Fadens sind hier durch Pfeile 24 angedeutet.

## Patentansprüche

1. Verfahren zur dreidimensionalen Darstellung von Maschen (10, 10', 10") auf einer Einrichtung zum Entwurf von auf einer Strick- oder Wirkmaschine hergestellten Maschenerzeugnissen mit mindestens einer Anzeigeeinrichtung, wobei die Masche (10, 10', 10") mit Hilfe einer Simulationseinrichtung durch eine Fläche dargestellt wird, die sich aus einer Anzahl von zweidimensionalen geometrischen Grundformen (11, 11', 11") zusammensetzt, wobei die Anzahl der Grundformen (11, 11', 11") abhängig von der gewünschten Darstellungsgröße der Masche (10, 10', 10") auf einer Anzeigeeinrichtung der Entwurfseinrichtung und/oder der Krümmung einzelner Maschenabschnitte (12, 13, 14, 15) gewählt wird und dass die räumliche Struktur der Masche (10, 10', 10") durch Schattierung und Texture Mapping dargestellt wird, **dadurch gekennzeichnet, dass** beim Texture Mapping die räumliche Struktur des die Masche bildenden Fadens (20) durch eine Normalvektor-Darstellung der Eckpunkte der Grundformen (11, 11', 11") erzeugt wird, wobei die Normalvektor-Darstellung jedes Eckpunktes vom Normalvektor des Fadens (20) in diesem Punkt abhängt und wobei für die Berechnung der Normalvektoren des Fadens (20) nur die jeweils für einen Betrachter sichtbare Seite des Fadens (20) durch einen Halbzylinder (21) mit einer Breite entsprechend dem Durchmesser des Fadens (20) angenähert wird.

2. Verfahren nach Anspruch 1, **dadurch gekennzeichnet, dass** die Anzahl der die Fläche bildenden Grundformen (11, 11', 11") umso höher gewählt wird, umso größer die Maschendarstellung auf der Anzeigeeinrichtung und/oder umso stärker die Krümmung einzelner Maschenabschnitte (12, 13, 14, 15) ist.

3. Verfahren nach Anspruch 1 oder 2, **dadurch gekennzeichnet, dass** die Fläche von lauter gleichartigen oder von unterschiedlichen Grundformen gebildet wird.

4. Verfahren nach einem der Ansprüche 1 bis 3, **dadurch gekennzeichnet, dass** die Grundformen ebene Polygone, insbesondere Dreiecke oder Vierecke sind.

5. Verfahren nach einem der vorhergehenden Ansprüche, **dadurch gekennzeichnet, dass** die Texturdaten auch Informationen über die Transparenz des Fadens (20) enthalten.

6. Einrichtung zum Entwurf von auf einer Strick- oder Wirkmaschine herzustellenden Maschenerzeugnissen mit mindestens einer Anzeigeeinrichtung zur Darstellung der Maschenerzeugnisse und einer Simulationseinrichtung zur Erzeugung dreidimensionaler Darstellungen der Maschen (10, 10', 10") des Maschenerzeugnisses, wobei die Simulationseinrichtung eine Einrichtung zur Annäherung der Form jeder Masche (10, 10', 10") durch zweidimensionale geometrische Grundformen (11, 11', 11") aufweist, wobei die Anzahl der Grundformen (11, 11', 11") in Abhängigkeit von der gewünschten Darstellungsgröße der Masche (10, 10', 10") wählbar und in stark gekrümmten Bereichen (12, 13, 14, 15) der Masche (10) größer wählbar ist als in weniger gekrümmten Bereichen und die Simulationseinrichtung eine Einrichtung zum Texture-Mapping enthält, **dadurch gekennzeichnet, dass** mit der Texture-Mapping Einrichtung die räumliche Struktur des die Masche (10, 10', 10") bildenden Fadens (20) als eine Normalvektor-Darstellung der Eckpunkte der Grundformen (11, 11', 11") erzeugbar ist, wobei die Normal-Vektordarstellung jedes dieser Punkte in Abhängigkeit vom Normalvektor des Fadens (20) an diesem Punkt erzeugbar ist und für die Berechnung der Normalvektoren des Fadens (20) nur die jeweils für einen Betrachter sichtbare Seite des Fadens (20) durch einen Halbzylinder (21) mit einer Breite entsprechend dem Durchmesser des Fadens (20) annäherbar ist.

7. Einrichtung nach Anspruch 6, **dadurch gekennzeichnet, dass** mit der Einrichtung zum Texture-Mapping die sichtbare Seite des Fadens (20) durch eine streifenförmige Fläche (23) mit einer Breite entsprechend dem Durchmesser des Fadens (20) darstellbar ist.

## Claims

1. Method for the three-dimensional illustration of stitches (10, 10', 10") on a means for designing knitted products produced on a knitting or textile machine, with at least one display means, wherein the stitch (10, 10', 10") is illustrated as a surface composed of a number of two-dimensional geometric base shapes (11, 11', 11") with the aid of a simulation means, wherein the number of base shapes (11, 11', 11 ") is selected depending on the desired illustration size of the stitch (10, 10', 10") on a display means of the design means and/or the curvature of individual stitch sections (12, 13, 14, 15), and in that the spatial structure of the stitch (10, 10', 10") is illustrated by shading and texture mapping,
**characterised in that**
the spatial structure of the thread (20) forming the stitch is created by a normal vector illustration of the corner points of the base shapes (11, 11', 11") during texture mapping, wherein the normal vector illustration of each corner point depends on the normal vector of the thread (20) at this point, and wherein only the respective side of the thread (20) that is visible to a viewer is approximated by a half-cylinder (21) with a width that equals the diameter of the thread (20) for calculating the normal vectors of the thread (20).

2. Method according to claim 1, **characterised in that** the number of base shapes (11, 11', 11 ") forming the surface is selected to be higher, the higher the stitch illustration is on the display means and/or the stronger the curvature of individual stitch sections (12, 13, 14, 15) is.

3. Method according to claim 1 or 2, **characterised in that** the surface is formed of a multitude of similar or different base shapes.

4. Method according to one of the claims 1 to 3, **characterised in that** the base shapes are flat polygons, in particular triangles or rectangles.

5. Method according to one of the preceding claims, **characterised in that** the texture data also includes information about the transparency of the thread (20).

6. Method for designing knitted products to be produced on a knitting or textile machine, with at least one display means for illustrating the knitted products, and a simulation means for creating three-dimensional illustrations of the stitches (10, 10', 10") of the knitted product, wherein the simulation means comprises a means for approximating the shape of each stitch (10, 10', 10") with two-dimensional geometric base shapes (11, 11', 11"), wherein the number of base shapes (11, 11', 11") can be selected depending on the desired illustration size of the stitch (10, 10', 10") and is greater in strongly curved areas (12, 13, 14, 15) of the stitch (10) than in less curved areas, the simulation means includes a means for texture mapping, **characterised in that** the spatial structure of the thread (20) forming the stitch (10, 10', 10") can be created as a normal vector illustration of the corner points of the base shape (11, 11', 11") with the texture mapping means, wherein the normal vector illustration of each one of these points can be created at this point depending on the normal vector of the thread (20) and only the respective side of the thread (20) that is visible to a viewer is approximated by a half-cylinder (21) with a width that equals the diameter of the thread (20) for calculating the normal vectors of the thread (20).

7. Means according to claim 6, **characterised in that** the visible side of the thread (20) can be illustrated by a stripe-shaped surface (23) with a width that equals the diameter of the thread (20) with the means for texture mapping.

## Revendications

1. Procédé de représentation en trois dimensions de mailles (10, 10', 10'') sur un dispositif de conception de produit à mailles fabriqué sur une machine à tricoter ou une machine de bonneterie, comprenant au moins un dispositif d'affichage, la maille (10, 10', 10'') étant représentée à l'aide d'un dispositif de simulation par une surface, qui se compose d'un certain nombre de formes (11, 11', 11'') de base géométriques en deux dimensions, dans lequel on choisit les formes (11, 11', 11'') de base en fonction de la grandeur de représentation souhaitée des mailles (10, 10', 10'') sur un dispositif d'affichage du dispositif de conception et/ou de la courbure des diverses parties (12, 13, 14, 15) de maille et en ce que l'on représente la structure spatiale des mailles (10, 10', 10'') par un ombrage et un texture mapping, **caractérisé en ce que**
dans le texture mapping, on produit la structure spatiale du fil (20) formant la maille, par une représentation à vecteur normal des points de coin des formes (11, 11', 11'') de base, la représentation par vecteur normal de chaque point de coin dépendant du vecteur normal du fil (20) en ce point et, pour le calcul des vecteurs normaux du fil (20), seul le côté du fil (20) visible pour un observateur est considéré en approximation par un hémicylindre (21) d'une largeur correspondant au diamètre du fil (20).

2. Procédé suivant la revendication 1, **caractérisé en ce que** l'on choisit le nombre des formes (11, 11', 11'') de base formant la surface, d'autant plus grand que la représentation de mailles sur le dispositif d'affichage est plus grande et/ou que la courbure des diverses parties (12, 13, 14, 15) de mailles est plus prononcée.

3. Procédé suivant la revendication 1 ou 2, **caractérisé en ce que** l'on forme la surface de formes de base nettement de même type ou différente.

4. Procédé suivant l'une des revendications 1 à 3, **caractérisé en ce que** les formes de base sont des polygones plans, notamment des triangles ou des rectangles.

5. Procédé suivant l'une des revendications précédentes, **caractérisé en ce que** les données de texture contiennent aussi des informations sur la transparence du fil (20).

6. Dispositif de conception de produit à mailles fabriqué sur une machine de bonneterie ou à tricoter, comprenant au moins un dispositif d'affichage pour représenter des produits à mailles et un dispositif de simulation pour produire des représentations en trois dimensions des mailles (10, 10', 10'') du produit à mailles, le dispositif de simulation ayant un dispositif pour prendre en considération approximativement la forme de chaque maille (10, 10', 10'') par des formes (11, 11', 11'') de base géométriques en deux dimensions, dans lequel le nombre des formes (11, 11', 11'') de base peut être choisi en fonction de la grandeur de représentation souhaitée des mailles (10, 10', 10'') et peut être choisi plus grand dans les parties (12, 13, 14, 15) à courbure prononcée de la maille (10) que dans des parties moins courbées et le dispositif de simulation comporte un dispositif de texture mapping, **caractérisé en ce que**
par le dispositif de texture mapping, la structure spatiale du fil (20) formant les mailles (10, 10', 10'') peut être produite sous la forme d'une représentation par vecteur normal des points de coin des formes (11, 11', 11'') de base, la représentation par vecteur normal de chacun de ces points pouvant être produite en fonction du vecteur normal du fil (20) en ce point et, pour le calcul des vecteurs normaux du fil (20), il n'est considéré que le côté du fil (20) visible pour un observateur, approximativement par un hémicylindre (21) d'une largeur correspondant au diamètre du fil (20).

7. Dispositif suivant la revendication 6, **caractérisé en ce que** le côté visible du fil (20) peut, par le dispositif de texture mapping, être représenté par une surface (23) en forme de bande, d'une largeur correspondant au diamètre du fil (20).
